(19) Europäisches Patentamt / European Patent Office / Office européen des brevets

(11) **EP 2 883 632 B1**

(12) **EUROPEAN PATENT SPECIFICATION**

(45) Date of publication and mention of the grant of the patent:
**05.07.2017 Bulletin 2017/27**

(21) Application number: **13196540.2**

(22) Date of filing: **10.12.2013**

(51) Int Cl.:
*B22F 3/11* (2006.01)    *B22F 7/00* (2006.01)
*B32B 15/01* (2006.01)    *C25D 5/10* (2006.01)
*C22C 1/08* (2006.01)    *C23C 16/56* (2006.01)
*C23C 14/00* (2006.01)    *C23C 14/04* (2006.01)
*C23C 14/20* (2006.01)    *C25D 1/08* (2006.01)

(54) **Metallic foam body with controlled grain size on its surface, process for its production and use thereof**

Metallschaumkörper mit kontrollierter Korngröße auf seiner Oberfläche, Verfahren zu seiner Herstellung und Verwendung

Corps en mousse métallique à granulométrie contrôlée sur sa surface, son procédé de production et son utilisation

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**17.06.2015 Bulletin 2015/25**

(73) Proprietor: **Alantum Europe GmbH 82041 Oberhaching (DE)**

(72) Inventors:
• **Poss, René, Dr.**
  **82054 Sauerlach (DE)**
• **Saberi, Shadi, Dr.**
  **82061 Neuried (DE)**
• **Deisel, Frank, Dr.**
  **82041 Oberhaching (DE)**

(74) Representative: **Manitz Finsterwald Patentanwälte PartmbB Martin-Greif-Strasse 1 80336 München (DE)**

(56) References cited:
EP-A1- 1 477 578    EP-A1- 2 650 393
WO-A2-2006/111837    JP-A- H08 225 866
US-A- 4 076 888

**Description**

The invention relates to a metallic foam body with controlled grain size on its surface, a process for its production and use thereof. In particular the invention relates to a metallic foam body, comprising (a) a metallic foam body substrate made of at least one metal or metal alloy A; and (b) a layer of a metal or metal alloy B present on at least a part of the surface of the metallic foam body substrate (a), wherein A and B differ in their chemical composition and/or in the grain size of the metal or metal alloy; a process for its production and a use thereof.

Metallic foams as precursor for catalysts or as catalysts are known. In fact, the potential advantages of metal foams as catalyst supports or catalysts have been the subject of significant attention in the chemical industry. Some of the characteristics of these foams are: large interfacial area that promotes mass and heat transfer, high thermal conductivity and mechanical strength.

In order to provide these favorable characteristics, the metallic foams have often to be produced by using a porous organic polymer as a template onto which one or more desired metals or metal alloys are deposited. The organic polymer is then burnt off at elevated temperatures to give rise to a metallic foam that can be used for a variety of applications including various adsorption and absorption processes; or as a catalytic material per se or a precursor thereof. However, in order to burn off the polymer, high temperatures need to be applied. For example, in the case of polyurethane as a template, the polyurethane template is burnt off at a temperature of up to 850°C. Under such temperature conditions many metallic surfaces change and often give rise to an increase in the grain size of metallic particles. As a result, desired surface characteristics of the metal may suffer.

EP 2 650 393 A1 discloses a method for producing a porous metal body containing at least nickel and tungsten, the method comprising a step of coating a porous nickel body with an alloy containing at least nickel and tungsten; and a step of subsequently performing a heat treatment to diffuse tungsten into the porous nickel body. The latter is obtained by coating, with nickel, a porous base having been made electrically conductive, removing the porous base, and subsequently reducing nickel. As porous base, a material that can be plated with metal and that then can be removed by incineration, for example a urethane foam, is preferred.

JP H08 225 866 A discloses a metallic porous body having a three-dimensional network structure and its production. Polyurethane foam as a resin having high porosity is immersed in a slurry containing spherical carbonyl iron powder to impregnate the slurry. The resin is then dried at room temperature and sintered in a non-oxidizing atmosphere to remove the resin such that an iron porous body having a three-dimensional network structure is formed. The surface of the iron skeleton is plated with nickel in a Watts bath, which is a kind of electroplating bath.

US 4,076,888 discloses a process for the production of metallic and/or metal ceramic and/or ceramic sponges having a three-dimensional cellular structure of filiform morphology, starting from a foamed polyurethane sponge, the process comprising coating a metalized polyurethane sponge with specific pores with at least one layer of at least one coating material selected from the class consisting of metal, metal-ceramic and ceramic materials, using a dry high-temperature coating technique consisting essentially of molten-spray deposition by a plasma spray.

WO 2006/111837 A2 discloses a method for production of metal, in particular a foam of silver or gold, comprising the deposition by chemical means of a thin first layer of metal such as silver or gold on the surface of the bubbles of a polyurethane foam or similar to give a metal foam and deposition by electrolytic means of a second layer of the same metal of greater thickness on the surface of the bubbles of the silver or gold foam.

EP 1 477 578 A1 discloses a method for producing a metal foam comprising the steps of providing an open cell core metal foam comprising a first metal or alloy and coating the cores metal foam with a second metal or alloy, which is applied onto the core metal foam in a liquid state. The first metal or alloy has thus a melting point that is higher than that of the second metal or alloy.

It is moreover known that the grain size of catalytically active species is of great importance for many catalyzed processes. Hence there is in general a need for the provision of catalytically active materials with a defined grain size of the catalytically active species. The grain size often increases during a catalyzed reaction, especially when this reaction is carried out at high temperatures. For example, the article "Herstellung von Formaldehyd aus Methanol in der BASF" describes the synthesis of formaldehyde by oxidative dehydration of methanol using a silver crystal catalyst at 600 to 700°C. It was found in this process that the yield decreases when the temperature of the silver catalyst increases in that the amount of non-converted methanol decreases and the formation of the side products carbon monoxide and dioxide increases. This was attributed to the fact that the grain size of the silver increases at the high temperature of 700 °C at which this so-called formaldehyde process is performed, leading to a decrease of the catalytic activity of the silver catalyst.

It is thus an object of the present invention to provide a metallic foam body with a controlled grain size of the metallic particles on the foam body surface, i.e. with a grain size that is less dependent on the synthesis conditions of the metallic foam body. An object of the invention is also the provision of a process for the production of such a metallic foam body.

This object is achieved by the metallic foam body, the process for the production of the metallic foam body and the use of the metallic foam body in accordance with the respective independent claims. Preferred embodiments of the metallic foam body, the process for its production as well as the use thereof are indicated in the respective dependent claims. Preferred embodiments of the metallic foam body, the process and the use correspond to preferred embodiments of the other invention categories, even when this is not explicitly indicated.

Accordingly, the invention is directed to a metallic foam body in accordance with claim 1, comprising

(a) a metallic foam body substrate made of at least one metal or metal alloy A; and
(b) a layer of a metal or metal alloy B present on at least a part of the surface of the metallic foam body substrate (a), wherein A and B differ in the grain size of the metal or metal alloy;

obtainable by a process comprising the steps

(i) provision of a porous organic polymer foam;
(ii) deposition of at least one metal or metal alloy A on the porous organic polymer foam;
(iii) burning off of the porous organic polymer foam to obtain the metallic foam body substrate (a); and
(iv) deposition by electroplating of the metallic layer (b) of a metal or metal alloy B at least on a part of the surface of the metallic foam body (a).

The deposition of at least one metal or metal alloy A on the porous organic polymer foam in step (ii) can be effected in various ways, for example by electroplating, CVD, Metal-Organic CVD (MOCVD), by a slurry method or another method. If electroplating is to be effected, the porous polymer has to be rendered in advance electrically conductive so that it becomes suitable for the electroplating process.

According to the invention, step (ii) thus comprises the steps

(ii1) deposition of a first metallic layer containing a metal or metal alloy A1 by a chemical or physical vapor deposition method; and
(ii2) deposition of a second metallic layer containing a metal or metal alloy A2 by electroplating;

wherein A1 and A2 are identical or different. In the context of the present invention, the meaning of A comprises A1 and A2.

In step (ii1) various chemical or physical vapor deposition methods can be used. Preferably, a sputtering method is used.

The first metallic layer serves in general to the purpose of rendering the surface of the porous organic polymer electrically conductive. Accordingly, the first metallic layer can be rather thin as long as it provides a sufficiently electrical conductivity. It is in general sufficient that this first metallic layer has a thickness in the order of a few atoms. Preferably, the average thickness of the first metallic layer is up to 0.1 $\mu$m and the average thickness of the second metallic layer is from 5 to 50 $\mu$m.

In the production of the metallic foam body of the present invention, numerous porous organic polymers can be used. Preferably, organic polymers with open pores are used. In general, the porous organic polymer foam is selected from the group consisting of polyurethane (PU) foam, poly ethylene foam and polypropylene foam. Most preferably, a porous polyurethane (PU) foam is used. The use of a porous polyurethane (PU) foam gives rise to a particular advantageous open-celled metallic foam body.

In a particular preferred embodiment of the metallic foam body, the thickness of struts in the metallic foam body substrate (a) is in the range of from 5 to 100 $\mu$m.

Preferably, the average thickness of the layer (b) of the metal or metal alloy B is from 5 to 200 $\mu$m.

In the metallic foam body of the present invention, the metal or metal alloy A1 is selected from a group consisting of Ni, Cr, Co, Cu, Ag, and any alloy thereof. According to the invention, A2 and B are silver. A1 may be also silver or a different metal or metal alloy. The selection of metal or metal alloy will depend to some extent on the intended application of the metallic foam body. For some catalytic purposes, the presence of a different metal might poison the silver.

As regards the present invention, the grain size is determined by electron microscopy. In the metallic foam body of the present invention, the grain size in the metallic foam body substrate (a) of a metal or metal alloy A is preferably in the range of from 1 $\mu$m to 100 $\mu$m. Moreover, the grain size in the layer (b) of a metal or metal alloy B is preferably in the range of from 1 nm to 50 $\mu$m.

The metallic foam body of the present invention has preferably a pore size of from 100 and 5000 $\mu$m, a strut thickness in the range of from 5 to 100 $\mu$m, an apparent density in the range of from 300 to 1200 kg/m$^3$, a specific geometrical surface area in the range of from 100 to 20000 m$^2$/m$^3$ and a porosity in the range of from 0.50 to 0.95.

The pore size is determined in general by a Visiocell analysis method from Recticel that is described in "The Guide 2000 of Technical Foams", Book 4, Part 4, pages 33-41. In particular, the pore size is determined with an optical measurement of cell diameter by superimposing calibrated rings, printed on transparent paper, on the selected cell. The pore size measurement is performed at least for hundred different cells in order to obtain an average cell diameter value.

The apparent density is determined as weight per volume unit according to ISO 845.

The geometrical surface area (GSA) of the metallic foam body is determined by using 2-D foam scans and numerical methods. In particular, the GSA was determined by using an imaging technique in the following way: A foam sample (20 x 20 mm) with hardener (mixture of resin and epoxy hardener in 10:3 weight ratio) is placed in a holder. The sample is hardened for 30 min at 70 °C oven temperature. The foam sample is polished by using a polishing disk and water. Image capture and processing is done with "Inner View" software. Images are captured from 36 districts (one district is 1.7 x 2.3 mm) and analysis of the captured images is done with the software. Three maximum and three minimum are removed and GSA evaluation is done based on 30 districts according to the equation

$$(A_s/V) = \Sigma_l (P_s/A_{total})_l / l$$

- Cross-sectional area ($A_{total}$)
- Strut area per cross-sectional area (As)
- Perimeter with strut per cross-sectional area (Ps)

The porosity (in %) is calculated by the following equation:

$$\text{Porosity } (\%) = 100 / VT \times (VT - W (1000/\rho),$$

wherein VT is the foam sheet sample volume, unit [mm$^3$]; W is the foam sheet sample weight, unit [g] and $\rho$ is the density of the foam material.

The strut thickness is measured by electron microscopy.

The layer of the metal or metal alloy B may be present on a part or the entire surface of the metallic foam body substrate (a). It is however preferred that the metal or metal alloy B is present on the entire surface of the metallic foam body substrate (a). It is moreover preferable that the layer (b) on the metallic foam body substrate (a) has a uniform thickness.

The invention relates moreover to a process for the production of a metallic foam body in accordance with claim 6, wherein the metallic foam body comprises

(a) a metallic foam body substrate made of at least one metal or metal alloy A; and
(b) a layer of a metal or metal alloy B present on at least a part of the surface of the metallic foam body substrate (a), wherein A and B differ in the grain size of the metal or metal alloy;

comprising the steps

(i) provision of a porous organic polymer foam;
(ii) deposition of at least one first metal or metal alloy A on the porous organic polymer foam;
(iii) burning off of the porous organic polymer foam to obtain the metallic foam body substrate (a); and
(iv) deposition by electroplating of the metallic layer (b) of a metal or metal alloy B at least on a part of the surface of the metallic foam body substrate, wherein step (ii) comprises the steps:

(ii1) deposition of a first metallic layer containing a metal or metal alloy A1 by a chemical or physical vapor deposition method; and
(ii2) deposition of a second metallic layer containing a metal or metal alloy A2 by electroplating; and wherein A1 and A2 are identical or different and wherein A1 is selected from a group consisting of Ni, Cr, Co, Cu, Ag, and any alloy thereof; and wherein A2 and B are silver.

A preferred process comprises the steps

(i1) provision of a porous polyurethane foam;
(ii3) deposition of Ag in a thickness of 5 to 50 $\mu$m onto the polyurethane foam; and

(iii1) burning off the polyurethane foam at a temperature in the range of from 300 to 850°C to obtain the metallic foam body substrate (a); and
(iv1) deposition of Ag in a thickness of 1 to 200 $\mu$m, more preferably 5 to 50 $\mu$m, by electroplating onto the metallic foam body substrate (a) obtained in step (iii1).

An even more preferred process comprises the steps

(i1) provision of a porous polyurethane foam;
(ii4) deposition of Ni or Ag by sputtering to render the polyurethane foam electrically conductive;
(ii5) deposition of Ag in a thickness of 5 to 50 $\mu$m by electroplating onto the electrically conductive polyurethane foam obtained in step (ii3); and
(iii1) burning off the polyurethane foam at a temperature in the range of from 300 to 850°C; and
(iv1) deposition of Ag in a thickness of 1 to 200 $\mu$m, more preferably 5 to 50 $\mu$m, by electroplating onto the metallic foam body substrate (a) obtained in step (iii1).

In a further aspect, the present invention relates to the use of the metallic foam body described herein in a physical adsorption or absorption process or in a chemical process.

Examples are the removal and recovery of metals from the liquid waste streams in pharmaceutical, refining and industrial applications.

The metallic foam body of the present invention can also be used as a component in catalyst formulations for numerous catalyzed chemical reactions which involve in particular organic compounds, for example hydrogenation, isomerization, hydration, hydrogenolysis, reductive amination, reductive alkylation, dehydration, oxidation, dehydrogenation, rearrangement and other reactions.

In a preferred use, the metallic foam body is used as a precursor for a catalyst or a catalyst in a process for the production of formaldehyde by oxidation of methanol.

The metallic foam bodies of the present invention show a high porosity, are light weight and have a large surface area. Moreover, they reveal a good structural homogeneity. As regards flow, mass and heat transfer characteristics, the surface modified metal foams allow a low pressure drop, an enhanced flow mixing, high heat transfer and mass transfer rates, high thermal conductivity and a low diffusion resistance.

The invention has several advantages. The invention allows to produce a catalyst or components for a catalyst to be used in a chemical process with a high mechanical stability and a very defined surface structure in that the grain size of the metallic particles on the foam body surface can be controlled. I.e. the grain size is less dependent on the synthesis conditions of the metallic foam body than with known foam bodies.

Moreover, the metallic foam body of the present invention enables good material transfer through it while the transferred material can come into contact with catalytic sites. Moreover, the use of the foam body of the present invention allows avoiding channeling.

The following examples serve to illustrate the invention and may not be construed to limit the present invention. Grain sizes as well as layer thicknesses were determined by scanning electron microscopy.

Example

A metallic foam body was produced by providing firstly a porous polyurethane foam with an average porosity of 450 $\mu$m as a 1.6 mm sheet. The polyurethane foam was subjected to sputtering with Ni (alternatively with Ag) to make the polyurethane foam electrically conductive. Then silver was electroplated in an average thickness of 20 $\mu$m. Thereafter, the polyurethane foam was burned off in air at a temperature of 700°C. After the burning off of the polyurethane foam the grain size had increased over the grain size directly after the deposition of the silver layer. Thereafter, a second silver layer with an average thickness of 20 $\mu$m was plated. The grain size of the final metallic foam body was similar to the grain size directly after deposition of the silver layer before the polyurethane foam was burned off.

Comparison Example

The Example was repeated except that a silver layer with an average thickness of 40 $\mu$m was electroplated after the polyurethane had been rendered electrically conductive. The grain size of the final metallic foam body was larger than the grain size of the final metallic foam body of the Example.

**Claims**

1. Metallic foam body, comprising

   (a) a metallic foam body substrate made of at least one metal or metal alloy A; and
   (b) a layer of a metal or metal alloy B present on at least a part of the surface of the metallic foam body substrate (a), wherein A and B differ in the grain size of the metal or metal alloy;

   obtainable by a process comprising the steps:

   (i) provision of a porous organic polymer foam;
   (ii) deposition of at least one metal or metal alloy A on the porous organic polymer foam;
   (iii) burning off of the porous organic polymer foam to obtain the metallic foam body substrate (a); and
   (iv) deposition by electroplating of the metallic layer (b) of a metal or metal alloy B at least on a part of the surface of the metallic foam body (a);

   wherein step (ii) comprises the steps:

   (ii1) deposition of a first metallic layer containing a metal or metal alloy A1 by a chemical or physical vapor deposition method; and
   (ii2) deposition of a second metallic layer containing a metal or metal alloy A2 by electroplating;

   wherein A1 and A2 are identical or different, and wherein A1 is selected from a group consisting of Ni, Cr, Co, Cu, Ag, and any alloy thereof; and
   wherein A2 and B are silver.

2. Metallic foam body according to claim 1, wherein the average thickness of the first metallic layer is from 0.1 to 3 $\mu$m and the average thickness of the second metallic layer is from 5 to 50 $\mu$m.

3. Metallic foam body according to claim 1 or 2, wherein the porous organic polymer foam is selected from the group consisting of polyurethane (PU) foam, polyethylene foam and polypropylene foam.

4. Metallic foam body according to any of claims 1 to 3, wherein the average thickness of the layer (b) of the metal or metal alloy B is from 5 to 200 $\mu$m.

5. Metallic foam body according to any of the claims 1 to 4, wherein the layer (b) of the metal or metal alloy B is present on the entire surface of the metallic foam body substrate (a).

6. Process for the production of a metallic foam body, wherein the metallic foam body comprises

   (a) a metallic foam body substrate made of at least one metal or metal alloy A; and
   (b) a layer of a metal or metal alloy B present on at least a part of the surface of the metallic foam body substrate (a), wherein A and B differ in the grain size of the metal or metal alloy;

   comprising the steps:

   (i) provision of a porous organic polymer foam;
   (ii) deposition of at least one first metal or metal alloy A on the porous organic polymer foam;
   (iii) burning off of the porous organic polymer foam to obtain the metallic foam body substrate (a); and
   (iv) deposition by electroplating of the metallic layer (b) of the metal or metal alloy B at least on a part of the surface of the metallic foam body substrate (a);

   wherein step (ii) comprises the steps:

   (ii1) deposition of a first metallic layer containing a metal or metal alloy A1 by a chemical or physical vapor deposition method; and
   (ii2) deposition of a second metallic layer containing a metal or metal alloy A2 by electroplating;

wherein A1 and A2 are identical or different, and wherein A1 is selected from a group consisting of Ni, Cr, Co, Cu, Ag, and any alloy thereof; and
wherein A2 and B are silver.

7. Process according to claim 6, comprising the steps:

(i1) provision of a porous polyurethane foam;
(ii3) deposition of Ag in a thickness of 5 up to 50 $\mu$m onto the polyurethane foam; and
(iii1) burning off the polyurethane foam at a temperature in the range of from 300 to 850°C to obtain the metallic foam body substrate (a); and
(iv1) deposition of Ag in a thickness of 1 to 200 $\mu$m by electroplating onto the metallic foam body substrate (a) obtained in step (iii1).

8. Use of the metallic foam body of any of claims 1 to 5 in a physical adsorption or absorption process or in a chemical process.

9. Use according to claim 8, wherein the metallic foam body of any of claims 1 to 5 is used as a precursor for a catalyst or a catalyst in a process for the production of formaldehyde by oxidation of methanol.

**Patentansprüche**

1. Metallschaumkörper, umfassend,

(a) ein Metallschaumkörpersubstrat, das aus einem Metall und/oder einer Metalllegierung A hergestellt ist; und
(b) eine Schicht aus einem Metall oder einer Metalllegierung B, die auf zumindest einem Teil der Oberfläche des Metallschaumkörpersubstrats (a) vorhanden ist, wobei sich A und B in der Korngröße des Metalls oder der Metalllegierung unterscheiden;

erhaltbar durch ein Verfahren, das die Schritte umfasst:

(i) Vorsehen eines porösen organischen Polymerschaums;
(ii) Abscheiden eines Metalls und/oder einer Metalllegierung A auf dem porösen organischen Polymerschaum;
(iii) Abbrennen des porösen organischen Polymerschaums, um das Metallschaumkörpersubstrat (a) zu erhalten; und
(iv) Abscheiden der Metallschicht (b) aus einem Metall oder einer Metalllegierung B durch Elektroplattieren zumindest auf einem Teil der Oberfläche des Metallschaumkörpers (a);

wobei Schritt (ii) die Schritte umfasst:

(ii1) Abscheiden einer ersten Metallschicht, die ein Metall oder eine Metalllegierung A1 enthält, durch ein chemisches oder physikalisches Dampfabscheidungsverfahren; und
(ii2) Abscheiden einer zweiten Metallschicht, die ein Metall oder eine Metalllegierung A2 enthält, durch Elektroplattieren;

wobei A1 und A2 identisch oder verschieden sind, und wobei A1 aus einer Gruppe ausgewählt ist, die aus Ni, Cr, Co, Cu, Ag und einer beliebigen Legierung davon besteht; und
wobei A2 und B Silber sind.

2. Metallschaumkörper nach Anspruch 1, wobei die durchschnittliche Dicke der ersten Metallschicht von 0,1 bis 3 $\mu$m beträgt, und die durchschnittliche Dicke der zweiten Metallschicht von 5 bis 50 $\mu$m beträgt.

3. Metallschaumkörper nach Anspruch 1 oder 2, wobei der poröse organische Polymerschaum aus der Gruppe ausgewählt ist, die aus Polyurethan-(PU-)Schaum, Polyethylenschaum und Polypropylenschaum besteht.

4. Metallschaumkörper nach einem der Ansprüche 1 bis 3, wobei die durchschnittliche Dicke der Schicht (b) aus dem Metall oder der Metalllegierung B von 5 bis 200 $\mu$m beträgt.

5. Metallschaumkörper nach einem der Ansprüche 1 bis 4, wobei die Schicht (b) aus dem Metall oder der Metalllegierung B auf der gesamten Oberfläche des Metallschaumkörpersubstrats (a) vorhanden ist.

6. Verfahren zur Herstellung eines Metallschaumkörpers, wobei der Metallschaumkörper umfasst

(a) ein Metallschaumkörpersubstrat, das aus einem Metall und/oder oder einer Metalllegierung A hergestellt wird; und
(b) eine Schicht aus einem Metall oder einer Metalllegierung B, die auf zumindest einem Teil der Oberfläche des Metallschaumkörpersubstrats (a) vorhanden ist, wobei sich A und B in der Korngröße des Metalls oder der Metalllegierung unterscheiden;

umfassend die Schritte:

(i) Vorsehen eines porösen organischen Polymerschaums;
(ii) Abscheiden eines ersten Metalls und/oder einer ersten Metalllegierung A auf dem porösen organischen Polymerschaum;
(iii) Abbrennen des porösen organischen Polymerschaums, um das Metallschaumkörpersubstrat (a) zu erhalten; und
(iv) Abscheiden der Metallschicht (b) aus dem Metall oder der Metalllegierung B durch Elektroplattieren zumindest auf einem Teil der Oberfläche des Metallschaumkörpersubstrats (a);

wobei Schritt (ii) die Schritte umfasst:

(ii1) Abscheiden einer ersten Metallschicht, die ein Metall oder eine Metalllegierung A1 enthält, durch ein chemisches oder physikalisches Dampfabscheidungsverfahren; und
(ii2) Abscheiden einer zweiten Metallschicht, die ein Metall oder eine Metalllegierung A2 enthält, durch Elektroplattieren;

wobei A1 und A2 identisch oder verschieden sind, und wobei A1 aus einer Gruppe ausgewählt wird, die aus Ni, Cr, Co, Cu, Ag und einer beliebigen Legierung davon besteht; und
wobei A2 und B Silber sind.

7. Verfahren nach Anspruch 6, umfassend die Schritte:

(i1) Vorsehen eines porösen Polyurethanschaums;
(ii3) Abscheiden von Ag in einer Dicke von 5 bis zu 50 $\mu$m auf dem Polyurethanschaum; und
(iii1) Abbrennen des Polyurethanschaums bei einer Temperatur im Bereich von 300 bis 850°C, um das Metallschaumkörpersubstrat (a) zu erhalten; und
(iv1) Abscheiden von Ag in einer Dicke von 1 bis 200 $\mu$m durch Elektroplattieren auf dem in Schritt (iii1) erhaltenen Metallschaumkörpersubstrat (a).

8. Verwendung des Metallschaumkörpers nach einem der Ansprüche 1 bis 5 in einem physikalischen Adsorptions- oder Absorptionsprozess oder in einem chemischen Prozess.

9. Verwendung nach Anspruch 8, wobei der Metallschaumkörper nach einem der Ansprüche 1 bis 5 als ein Vorläufer für einen Katalysator oder als ein Katalysator in einem Verfahren zur Herstellung von Formaldehyd durch Oxidation von Methanol verwendet wird.

**Revendications**

1. Corps en mousse métallique, comprenant :

(a) un substrat de corps en mousse métallique réalisé en au moins un métal ou un alliage métallique A ; et
(b) une couche d'un métal ou d'un alliage métallique B présente sur au moins une partie de la surface du substrat de corps en mousse métallique (a), où A et B se distinguent par la dimension du grain du métal ou de l'alliage métallique ;

pouvant être obtenu par un procédé comprenant les étapes de :

(i) fourniture d'une mousse polymère organique poreuse ;
(ii) dépôt d'au moins un métal ou un alliage métallique A sur la mousse polymère organique poreuse ;
(iii) brûlage de la mousse polymère organique poreuse pour obtenir le substrat de corps en mousse métallique (a) ; et
(iv) dépôt par électrodéposition de la couche métallique (b) d'un métal ou d'un alliage métallique B au moins sur une partie de la surface du substrat de corps en mousse métallique (a) ;

dans lequel l'étape (ii) comprend les étapes de :

(ii1) dépôt d'une première couche métallique contenant un métal ou un alliage métallique A1 par un procédé de dépôt chimique ou physique en phase vapeur ; et
(ii2) dépôt d'une deuxième couche métallique contenant un métal ou un alliage métallique A2 par électrodéposition ;

dans lequel A1 et A2 sont identiques ou différents, et dans lequel A1 est choisi dans un groupe consistant en Ni, Cr, Co, Cu, Ag, et tout alliage de ces éléments ; et
dans lequel A2 et B représentent l'argent.

2. Corps en mousse métallique selon la revendication 1, dans lequel l'épaisseur moyenne de la première couche métallique est comprise entre 0,1 et 3 $\mu$m et l'épaisseur moyenne de la deuxième couche métallique est comprise entre 5 et 50 $\mu$m.

3. Corps en mousse métallique selon la revendication 1 ou 2, dans lequel la mousse polymère organique poreuse est choisie dans le groupe consistant en une mousse de polyuréthane (PU), une mousse de polyéthylène et une mousse de polypropylène.

4. Corps en mousse métallique selon l'une des revendications 1 à 3, dans lequel l'épaisseur moyenne de la couche (b) du métal ou de l'alliage métallique B est comprise entre 5 et 200 $\mu$m.

5. Corps en mousse métallique selon l'une des revendications 1 à 4, dans lequel la couche (b) du métal ou de l'alliage métallique B est présente sur la totalité de la surface du substrat de corps en mousse métallique (a).

6. Procédé de production d'un corps en mousse métallique, dans lequel le corps en mousse métallique comprend :

(a) un substrat de corps en mousse métallique réalisé en au moins un métal ou un alliage métallique A ; et
(b) une couche d'un métal ou d'un alliage métallique B présente sur au moins une partie de la surface du substrat de corps en mousse métallique (a), où A et B se distinguent par la dimension du grain du métal ou de l'alliage métallique ;

comprenant les étapes de :

(i) fourniture d'une mousse polymère organique poreuse ;
(ii) dépôt d'au moins un premier métal ou un alliage métallique A sur la mousse polymère organique poreuse ;
(iii) brûlage de la mousse polymère organique poreuse pour obtenir le substrat de corps en mousse métallique (a) ; et
(iv) dépôt par électrodéposition de la couche métallique (b) du métal ou de l'alliage métallique B au moins sur une partie de la surface du substrat de corps en mousse métallique (a) ;

dans lequel l'étape (ii) comprend les étapes de :

(ii1) dépôt d'une première couche métallique contenant un métal ou un alliage métallique A1 par un procédé de dépôt chimique ou physique en phase vapeur ; et
(ii2) dépôt d'une deuxième couche métallique contenant un métal ou un alliage métallique A2 par électrodéposition ;

dans lequel A1 et A2 sont identiques ou différents, et dans lequel A1 est choisi dans un groupe consistant en Ni, Cr, Co, Cu, Ag, et tout alliage de ces éléments ; et
dans lequel A2 et B représentent l'argent.

7. Procédé selon la revendication 6, comprenant les étapes de :

(i1) fourniture d'une mousse de polyuréthane poreuse ;
(ii3) dépôt de l'Ag en une épaisseur comprise entre 5 et 50 $\mu$m sur la mousse de polyuréthane ; et
(iii1) brûlage de la mousse de polyuréthane à une température comprise dans la plage allant de 300 à 850°C pour obtenir le substrat de corps en mousse métallique (a) ; et
(iv1) dépôt de l'Ag en une épaisseur comprise entre 1 et 200 $\mu$m par électrodéposition sur le substrat de corps en mousse métallique (a) obtenu à l'étape (iii1)

8. Utilisation du corps en mousse métallique de l'une des revendications 1 à 5 dans un procédé d'adsorption ou d'absorption physique ou dans un procédé chimique.

9. Utilisation selon la revendication 8, le corps en mousse métallique de l'une des revendications 1 à 5 étant utilisé comme un précurseur pour un catalyseur ou un catalyseur dans un procédé de production de formaldéhyde par oxydation de méthanol.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2650393 A1
- JP H08225866 A
- US 4076888 A
- WO 2006111837 A2
- EP 1477578 A1

**Non-patent literature cited in the description**

- The Guide 2000 of Technical Foams. 33-41